Europäisches Patentamt

European Patent Office

Office européen des brevets

(11) EP 0 841 671 A2

(19)

(12) # EUROPEAN PATENT APPLICATION

(43) Date of publication:
13.05.1998 Bulletin 1998/20

(51) Int Cl.⁶: H01G 4/12

(21) Application number: 97308967.5

(22) Date of filing: 07.11.1997

(84) Designated Contracting States:
AT BE CH DE DK ES FI FR GB GR IE IT LI LU MC NL PT SE
Designated Extension States:
AL LT LV MK RO SI

(30) Priority: 09.11.1996 GB 9623460

(71) Applicant: OXLEY DEVELOPMENTS CO., LTD.
Ulverston Cumbria LA12 9QG (GB)

(72) Inventors:
• Edwards, Geoffrey Stephen
  Grange over Sands, Cumbria, LA11 7QB (GB)
• Tavernor, Andrew William
  Walton, Wakefield, WF2 6LL (GB)
• Bell, Andrew John
  Grange over Sands, Cumbria, LA11 6BX (GB)

(74) Representative: W.P. THOMPSON & CO.
Coopers Building,
Church Street
Liverpool L1 3AB (GB)

(54) **Electronic components incorporating capacitors**

(57)    An electronic component comprising a discoidal, multi-layer, multi-composition capacitor, which capacitor is fabricated by stacking and co-firing a plurality of differing ceramic composition layers between a plurality of metallic electrodes to form a ceramic block, the ceramic composition layers having been selected so that the compositions are compatible for co-firing and also so that each layer of a different composition exhibits a respective peak in its permittivity at a different temperature, from that of the other compositions, within a selected temperature range, wherein the number of layers and thickness of layers for each composition is selected such that the total capacitance becomes substantially equal across the complete selected temperature range when the layers are connected in parallel within the ceramic block, and wherein the disc shape of the capacitor is formed from the ceramic block before it is incorporated in the electronic component.

Fig. 1

EP 0 841 671 A2

Fig. 2

**Description**

The present invention relates to electronic components incorporating capacitors.

In modern electronic circuitry there is an increasing need for the miniaturisation of discrete electronic components such as filters and pressure sensors, which incorporate a capacitor within their structure.

It is known to fabricate capacitors using layers of a particular ceramic material, which layers are co-fired with two or more spaced electrodes to build up the required capacitor structure. For this known type of structure, the capacitance, C, of the multi-layer capacitor thus formed is given by the formula:

$$C = N \frac{\varepsilon_o \varepsilon_r A}{t}$$

where

N = number of layers of thickness t connected in parallel
A = area of the electrodes
$\varepsilon_o$ = permittivity of free space
$\varepsilon_r$ = relative permittivity of the ceramic

Hence, in order to maximise the capacitance per unit volume, and thereby reduce the overall size of the capacitor, and thereby the overall size of the discrete electronic component incorporating the capacitor, it is necessary to maximise the relative permittivity $\varepsilon_r$ of the ceramic and reduce the overall thickness t. Most materials with a high permittivity also exhibit a large temperature dependence, often with a peak in the permittivity within a particular temperature range of application. Most applications require a more benign temperature dependence, the most popular being the so-called X7R specification in which, over the temperature range -55°C to + 125°C, the capacitance of the device should vary by less than 15% from its value at 25°C. In principle, for a conventional capacitor, this means that the relative permittivity of its ceramic, $\varepsilon_r$, is subject to the same constraints. Thus, there is a limitation on the maximum value of permittivity.

Therefore, the use of conventional ceramics with an acceptable temperature dependence of permittivity (and hence capacitance) results in a limitation on the maximum value of permittivity. Most ceramics which conform to an X7R specification have a nominal relative permittivity in the range of 2000-4000.

The fabrication of a multi-layer, multi-composition capacitor is described in European Patent Application No. 95300394.4 (Oxley Developments Company Limited). This capacitor has an improved capacitance/temperature characteristic.

It is an object of the present invention to overcome or alleviate the above described drawbacks of components using the known materials.

In accordance with a first aspect of the present invention there is provided an electronic component comprising a discoidal, multi-layer, multi-composition capacitor, which capacitor is fabricated by stacking and co-firing a plurality of differing ceramic composition layers between a plurality of metallic electrodes to form a ceramic block, the ceramic composition layers having been selected so that the compositions are compatible for co-firing and also so that each layer of a different composition exhibits a respective peak in its permittivity at a different temperature, from that of the other compositions, within a selected temperature range, wherein the number of layers and thickness of layers for each composition is selected such that the total capacitance becomes substantially equal across the complete selected temperature range when the layers are connected in parallel within the ceramic block, and wherein the disc shape of the capacitor is formed from the ceramic block before it is incorporated in the electronic component.

The layers of several different ceramic compositions, having different temperature dependence of capacitance, are combined in the multi-layer capacitor in such a way as to provide a capacitor with a temperature variation of capacitance within a required specification, but with a much larger capacitance per unit volume that can be achieved with a single ceramic composition. This allows capacitors to be manufactured which have either:

(i) the same volume as conventional multi-layered capacitors, but with a much larger value of capacitance;
(ii) the same capacitance as conventional multi-layer capacitors, but with a much smaller volume, accomplished by either a reduction in electrode area, or a reduction in the number of layers used to construct the stack, with a consequent reduction in total thickness, or a combination of the two;
(iii) the same volume and capacitance as conventional multi-layer capacitors, but an increased layer thickness and therefore an ability to withstand higher applied voltages, or
(iv) any combination of (i), (ii) and (iii).

The reduction in size of the capacitor has the advantage that the overall size of the electronic component can be reduced.

Preferably, alternate electrodes within the ceramic block are connected to a first and second end termination, respectively.

Preferably, the electronic component is a radio frequency interference suppression filter.

Preferably, the electronic component comprises two discoidal multi-layer, multi-composition capacitors fashioned from the same block of ceramic. This has the advantage that the electronic component can be used a pi-section, surface mount radio frequency interference suppression filter. Preferably, an end termination of one capacitor is connected to an end termination of the other capacitor.

Preferably, the connection between said end terminations is an inductance link provided by a conducting double spiral on a surface of the block. Preferably, each capacitor is connected between a respective end termination and a central earth terminal.

Preferably, a high magnetic permeability layer is provided on the surface of the block. This has the advantage of increasing the inductance of the spiral inductor. Preferably, the high magnetic permeability layer comprises a ferrite.

Preferably, the electronic component comprises an array of discoidal multi-layer, multi-component capacitors fashioned from a single block of ceramic. This has the advantage that the electronic component can constitute a so-called "planar array", used to act as a radio frequency interference suppression filter on an array of interconnections, such as a multi-way connector.

Conventionally, the application of planar arrays is limited by the density of interconnections, the capacitance value required and the operating voltage of the connector. That is, for large values of capacitance, a planar array may not be feasible for a particular pin density because the capacitance per unit volume offered by known materials, which fall within the required temperature specification, is insufficient. The advantage of the multi-layer, multi-component system is that the electrode area, for any given capacitance, can be reduced with respect to current technology and therefore the pin density can be increased.

Furthermore, cross-talk between elements on the array can be reduced. The high relative permittivity of the multi-layer, multi-composition ceramic between neighbouring electrodes tends to increase the leakage of signals between channels of the array.

In order to achieve a local reduction of the relative permittivity between elements of the array in the plane of the layers, it is preferred for areas of the layers to be selectively printed with a dopant before firing the ceramic block.

In a preferred embodiment, the dopant is printed on alternate layers in the spaces not occupied by the electrodes. This has the advantage that the dopant species will diffuse during firing into the selected regions of the ceramic and thereby accomplish the required reduction in the permittivity, without reducing the overall capacitance of individual elements in the array.

The operating voltage of a planar array is at present limited, as the need to achieve a sufficiently high capacitance can demand that the layer thickness be below that required to prevent voltage breakdown. With the high capacitance per unit volume of the multi-component, multi-layer system, larger values of capacitance can be achieved within the required temperature specification without reducing the layer thickness and compromising the breakdown voltage. Alternatively, to accommodate particularly high operating voltages, the layer thickness can be increased beyond that normally employed with current technology, so that the working voltage is increased without reducing the capacitance.

Preferably, the electronic component is a temperature stable pressure sensor.

In accordance with a second aspect of the present invention there is provided a temperature stable pressure sensor comprising a multi-layer, multi-composition capacitor, which capacitor is fabricated by stacking and co-firing a plurality of differing ceramic composition layers between metallic electrodes to form a ceramic block, the ceramic composition layers having been selected so that the compositions are compatible for co-firing and also so that each layer of a different composition exhibits a respective peak in its permittivity at a different temperature, from that of the other compositions, within a selected temperature range, wherein the number of layers and thickness of layers for each composition is selected such that the total capacitance becomes substantially equal across the complete selected temperature range when the layers are connected in parallel within the ceramic block.

In one embodiment, a temperature stable pressure sensor comprises a discoidal multi-layer, multicomposition capacitor housed inside a body of the sensor, one face of the capacitor being coupled to a pressure plate and the other end being fixed relative to the sensor body, such that pressure applied in use to the pressure plate causes elastic compression of the capacitor, resulting in a measurable variation of the capacitance of the capacitor related to the applied pressure.

Conventional materials, e.g. barium titanate have neither sufficiently high permittivity nor pressure sensitivity to act as a sensor. Lead-based perovskite ceramics such as lead magnesium niobate are sufficiently sensitive, but the sensitivity changes as a function of temperature in relation to their relative permittivity. Such temperature variation is unacceptable. The multi-layer, multi-component structure offers a means of providing a sufficiently temperature independent capacitance, and hence temperature independent pressure sensitivity. Furthermore, the multi-component structure allows the overall size of the capacitor, and hence the pressure sensor to be reduced as described above.

Preferably, the capacitor is a discoidal multi-layer, multi-composition capacitor. In a preferred embodiment, the capacitor is discoidal and is incorporated in a radial or isostatic pressure sensor.

Preferably, the capacitor is a single chip multi-layer, multi-composition capacitor. In a further preferred embodiment, the capacitor is a uniaxial or shear mode pressure sensor.

In accordance with a third aspect of the present invention there is provided a multi-layer, multi-composition capacitor fabricated by stacking and co-firing a plurality of different composition layers between metallic electrodes to form a ceramic block, the ceramic composition layers having been selected such that the differing compositions are compatible for co-firing and such that each layer of a different composition exhibits a respective peak in its permittivity at a different temperature from that of the other compositions, within a selected temperature range, wherein the number of layers and thickness of layers for each composition is selected such that the total capacitance becomes substantially equal across the complete selected temperature range when the layers are connected in parallel within the ceramic block.

The advantage of this structure is that the relative permittivity and hence the capacitance can be increased for a given temperature range. This allows the size of the capacitor to be decreased for any given capacitance, or the capacitance to be increased for any given volume.

Preferably, the thickness of the individual layers is equal. This has the advantage that the manufacture of the layers is simplified.

Preferably, the thickness of the individual layers vary. This has the advantage that the ceramic can be constructed from layers having fractional layer weightings which allows a larger choice of layer combinations to produce a given capacitor.

In a preferred embodiment the ceramic composition of the differing layers is based on lead magnesium niobate (PMN). This has the advantage that the different layers will be compatible for co-firing and the various compositions of PMN can be selected having a variety of peaks in permittivity.

Preferably, the ceramic composition is fabricated by selectively doping areas of the layers of PMN. Preferably, the dopant is $La_2O_3$. This has the advantage of reducing the temperature at which the peak in permittivity occurs. Preferably, the dopant is $PbTiO_3$. This has the advantage of increasing the temperature at which the peak in permittivity occurs. In short, the permittivity of the individual layers can be selectively adjusted to construct a stack/block having the required capacitance for a given temperature range.

In some preferred embodiments, only alternate layers of the stack/block have been selectively doped.

In one preferred embodiment, the ceramic block is constructed from six different compositions as follows:

I $Pb(Mg_{1/3}Nb_{2/3})O_3$
II $0.94\ Pb(Mg_{1/3}Nb_{2/3})O_3 - 0.06\ PbTiO_3$
III $0.9\ Pb(Mg_{1/3}Nb_{2/3})O_3 - 0.1\ PbTiO_3$
IV $0.85\ Pb(Mg_{1/3}Nb_{2/3})O_3 - 0.15\ PbTiO_3$
V $0.77\ Pb(Mg_{1/3}Nb_{2/3})O_3 - 0.23\ PbTiO_3$
VI $Pb_{0.985}La_{0.01}(Mg_{1/3}Nb_{2/3})O_3$

Preferably, the block is constructed from one layer of composition I, zero to three layers of composition II, one to three layers of composition III, zero to three layers of composition IV, zero to three layers of composition V, and three to six layers of composition V1.

This has the advantage that a capacitor can be constructed which exhibits the X7R characteristic.

Preferably, the block is constructed from one to four layers of composition II, one layer of composition IV, zero to three layers of composition V, and three to six layers of composition VI. A capacitor of this structure also exhibits an X7R characteristic.

In the case of the present MCMLS capacitor, the so-called X7R specification is expressed as

$$0.85C(25°C) \leq C(T) \leq 115C(25°C),\ -55°C \leq T \leq +125°C$$

where

$$C(T) = \varepsilon_o A \sum_{i=1}^{N} \frac{\varepsilon_r(T)_i}{t_i}$$

in which $\in r(T)i$ and $ti$ are the relative permittivity and thickness of the $i^{th}$ of N layers in the MCMLS capacitor of electrode area A and C (T) is its total capacitance at any temperature, T.

The invention is now described further, by way of example only, with reference to the accompanying drawings, in which:-

Fig. 1 is a diagrammatic sectional view through one embodiment of multi-layer, multi-composition device in accordance with the present invention;

Fig. 2 is a cross-sectional view along the line X-X of Fig. 1;

Fig. 3a to 3d are diagrammatic views of a second embodiment of multi-layer, multi-composition device in accordance with the present invention;

Fig. 4 is a cross-sectional view along the line X-X of Fig. 3a;

Fig. 5 is a sectional view through a multi-layer, multi-composition capacitor employed in the embodiments of Figs. 1 and 3.

Figs. 6 and 6a illustrate how the use of a plurality of layers with different, unstable temperature characteristics can result in a device having a stable characteristic when connected in parallel;

Fig. 7 illustrates the situation achieved using three different layers in a practical example;

Fig. 8 shows a pressure sensor incorporating a multi-layer, multi-composition capacitor as another example of a device constructed in accordance with the present invention;

Fig. 9 shows a C-section surface mount filter as a still further example of a filter constructed in accordance with the present invention;

Fig. 10 is a diagrammatic view of a second embodiment of multi-layer, multi-composition device in accordance with the present invention;

Fig. 11 is a cross-sectional view along the line X-X of Fig. 10;

Fig. 12 is a cross-sectional view along the line Y-Y of Fig. 10;

Fig. 13 is a cross-sectional view along the line Z-Z of Fig. 10; and

Fig. 14 is an equivalent circuit of the device of Fig. 10.

The capacitor device of Fig. 5 comprises a plurality of ceramic layers ($L_1, L_2, L_3 ..... L_n$), each of which (or at least some of which) are disposed in a stack together with a plurality of planar inner electrodes 10, alternate ones of which are connected to first and second end terminations 12a, 12b respectively. The stack of ceramic layers and electrodes are co-fired to produce a multi-composition, multi-layer monolithic ceramic block structure, referred to hereinafter as a MCMLS. The ceramic layers are preferably in the form of tape cast thick film layers of different electro-ceramic compositions.

The selection criteria used in establishing the composition of the various layers of the parallel structure are the ability for each (different) composition layer to survive and be compatible with its neighbour at the very high temperature involved in co-firing/sintering. When the material system described hereinafter and based on PMN/PT is used, a particular advantage is gained that the material has relatively low firing temperatures (700° - 1200°C) compared to the firing of conventional materials (typically 1400°C - 1600°C).

Using the present materials, the atmosphere can be either air, inert or reducing. This allows a wider choice of electrodes than normal. The electrode material, e.g. palladium, has also of course to be compatible with the PMN/PT system. Additionally, it is important that cross contamination between (different) layers does not occur during co-firing because this would degrade the electrical performance of the layer and thus its capacitance. This feature is assisted by the electrode which can itself act as a barrier layer to cross contamination.

As shown in the diagrammatic curves of Fig. 6, each different layer has its own particular capacitance/temperature characteristic A,B,C, etc.

When combined together as a result of the parallel structure resulting from the fabrication technique described hereinbefore, the resultant sum of the various characteristics has the form indicated at Y.

This is illustrated further by Fig. 6a which shows the different temperature coefficient of capacitance (TCC) curves for just two different materials in the layered stack. The average is the summation of each curve at a given temperature ie. $Y_1 + Y_2 = Y_3$ at the temperature $t_1$ in Fig. 6a.

Novel powder processing techniques are employed to produce the chemically differing compositions having substantially the same sintering characteristics to enable co-firing of all the layers to form the device.

One preferred system is based on lead magnesium niobate (PMN) and lead titanate (PT) materials mixed in varying proportions according to the general formula:

$$1\text{-}x\{Pb(Mg_{\frac{1}{3}}Nb_{\frac{2}{3}})O_3\} + x\{PbTiO_3\} \Rightarrow Pb(Mg_{\frac{1-x}{3}}Nb_{\frac{2(1-x)}{3}}Ti_x)O_3$$

where 1mol% < x < 35mol%.

## Example 1

A particular example based on this formula is illustrated in Fig. 12 wherein three layers have different compositions corresponding to the value X in the formula being 10% and 15%, ie:

Layer 1 = PMN
Layer 2 = PMN/10% PT
Layer 3 = PMN/15% PZ

(nb PZ is the same formula as given above but with Titanium (Ti) replaced by Zirconium (Zr) ).

The multilayer structure comprises three layers of equal thickness (typically 100 microns), or multiples of this triplet to achieve the capacitance required.

Fig. 7 shows the three different curves corresponding to the individual PMN, PMN/10% PT and PMN/15% PZ and also the resulting summation.

A generic extension is to add varying quantities of lead-zirconate (PZ) to improve the high temperature stability and thus give an even wider operating regime.

## Example 2

Combinations of a number of compositions based on PMN with a high permittivity and with peaks in the permittivity at temperatures within the range -55°C to + 125°, for example one composition with a peak around 35°C, another around -30°C, and another around 100°C, are prepared by doping with $La_2O_3$ or $PbTiO_3$. The addition of $La_2O_3$ reduces the temperature of the peak of the permittivity of PMN. The addition of $PbTiO_3$ increases the temperature at which the peak occurs. Given that the peak value of permittivity is different for each composition, the number of layers and thickness of the layers for each composition in the multi-layer is adjusted, such that the total capacitance becomes approximately equal across the complete temperature range, and the temperature dependence of total capacitance meets the required criteria.

Specific embodiments of the MCMLS capacitor are constructed from combinations of layers made from one of the following ceramic compositions.

I $Pb(Mg_{1/3}Nb_{2/3})O_3$
II $0.94\ Pb(Mg_{1/3}Nb_{2/3})O_3 - 0.06\ PbTiO_3$
III $0.9\ Pb[Mg_{1/3}Nb_{2/3}]O_3 - 0.1\ PbTiO_3$
IV $0.85\ Pb(Mg_{1/3}Nb_{2/3})O_3 - 0,15\ PbTiO_3$
V $0.77\ Pb(Mg_{1/3}Nb_{2/3})O_3 - 0.23\ PbTiO_3$
VI $Pb_{0.985}La_{0.01}(Mg_{1/3}Nb_{2/3})O_3$

Composition II is a ceramic consisting of 94% lead magnesium niobate and 6% lead titanate. However, the ceramic is not a mixture of two lead compounds, but rather a single compound or "solid solution". The above notation is used for convenience and ease of interpretation. Composition II could therefore be expressed as

$$Pb\ Mg_{0.3133}\ Nb_{0.6267}\ Ti_{0.06}O_3$$

The same principle applies to the other compositions.

In the following two examples of multi-layer capacitors, the inter-electrode thicknesses are equal. The relative number of layers of each composition to obtain the X7R temperature characteristic is as follows:

| Composition | Example 1 | Example 2 |
|---|---|---|
| I | 1 | 0 |
| II | 0-3 | 1-4 |
| III | 1-3 | 0 |
| IV | 0-3 | 1 |

(continued)

| Composition | Example 1 | Example 2 |
|---|---|---|
| V | 0-3 | 0-3 |
| VI | 3-6 | 3-6 |

Any capacitor containing the same multiple of all specified numbers of layers will exhibit the X7R characteristic.

Also, a ceramic can be constructed having fractional layer weightings. That is, a layer having twice the standard thickness will count as half a layer, a layer with three times the thickness as a third of a layer. Hence, with the above examples, a large number of structures with different layer counts and thicknesses are possible which exhibit the require X7R temperature coefficient, provided they conform to the limits of the specified layer count ratios.

The use of lead based relaxor ferroelectric ceramics in some embodiments allows sintering of the structure at temperatures of <1000°C thus enabling the use of lower cost base metal electrodes.

The device may also be fabricated from other dielectric materials, where each layer is chosen for the temperature characteristics desired.

The disc shape of a discoidal multi-layer, multi-composition ceramic capacitor is formed in that the disc shape is pressed or routed out of a ceramic block constructed as described above.

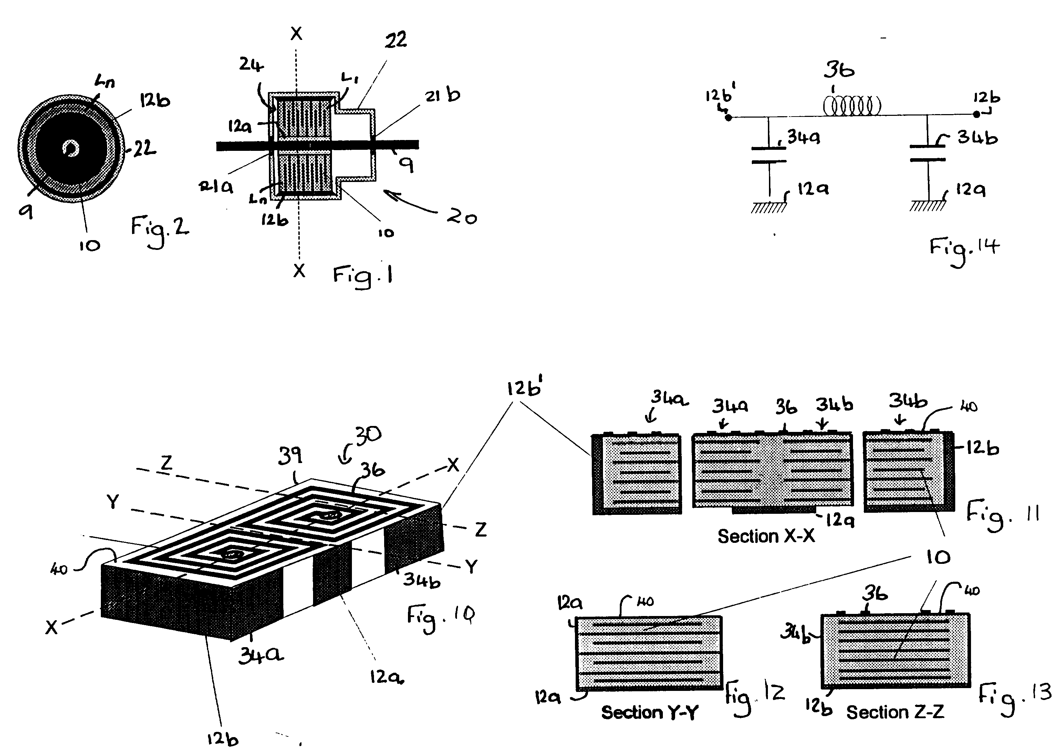

Figs. 1 and 2 illustrate a first embodiment of an electronic component incorporating a discoidal multi-layer, multi-component capacitor. The electronic component is a radio frequency interference suppression filter 20 with high volumetric efficiency, used to filter high frequencies from a conductor 9.

The filter 20 is adapted to be provided about a conductor 9 and for this purpose comprises a housing 22 and a discoidal multi-component, multi-layer capacitor 24. The end terminal 12b is connected to the housing 22, whilst the end terminal 12a is connected to the conductor 9. The housing 22 is isolated from the conductor 9 by a pair of insulators 21a,21b.

Figs. 10-14 illustrates a further embodiment of an electronic component incorporating multi-layer, multi-component capacitors. The electronic component is a Pi-section, surface mount radio frequency interference suppression filter 30.

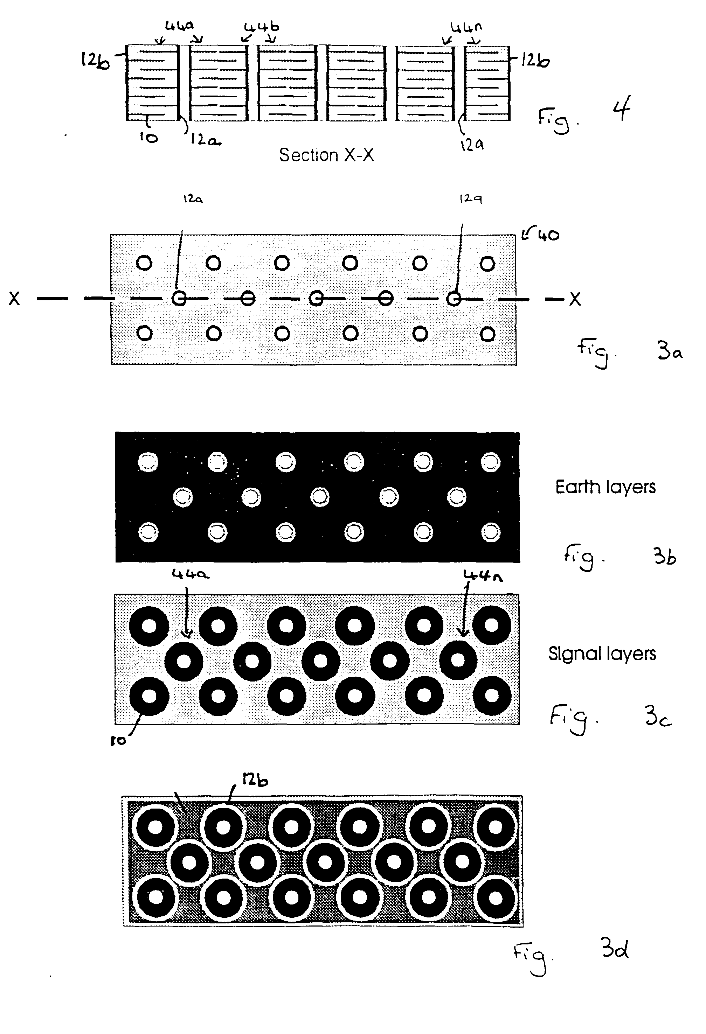

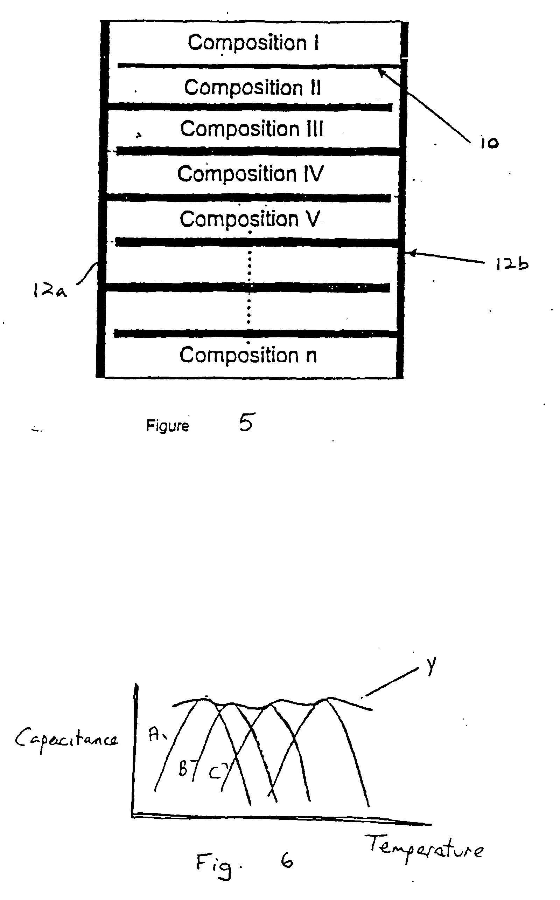

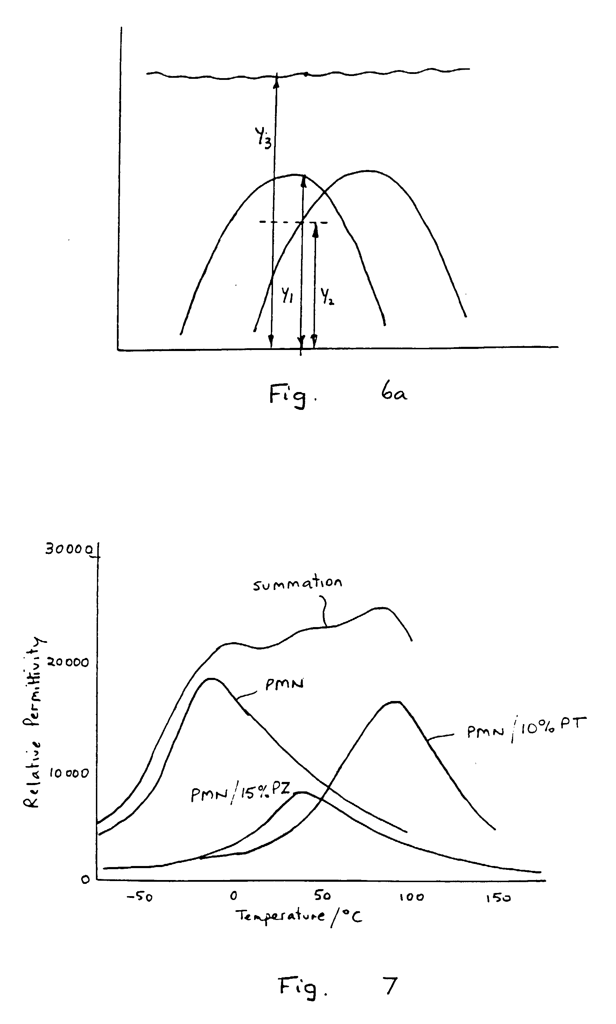

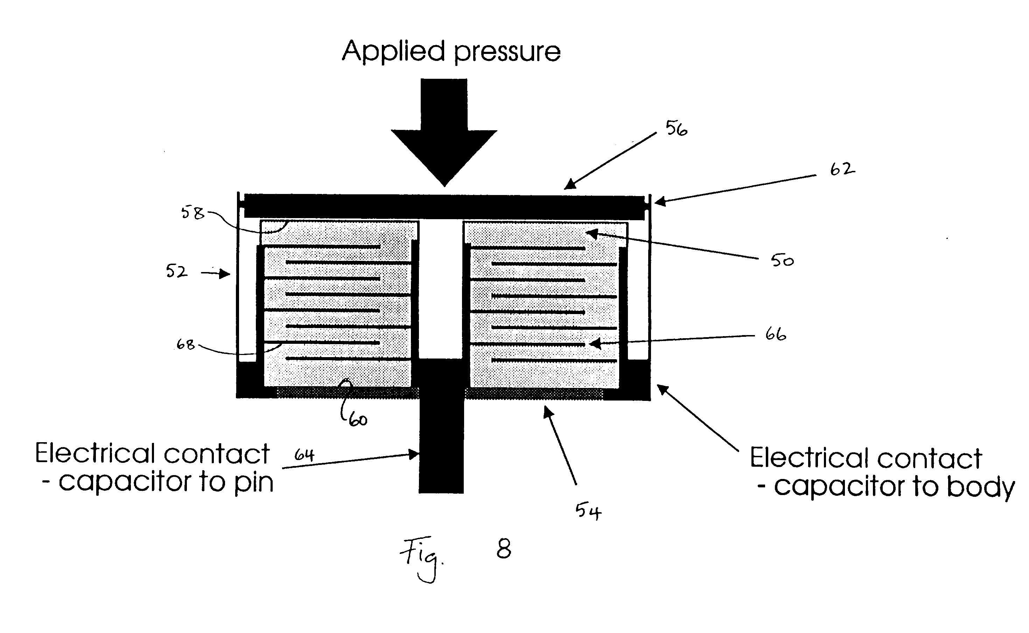

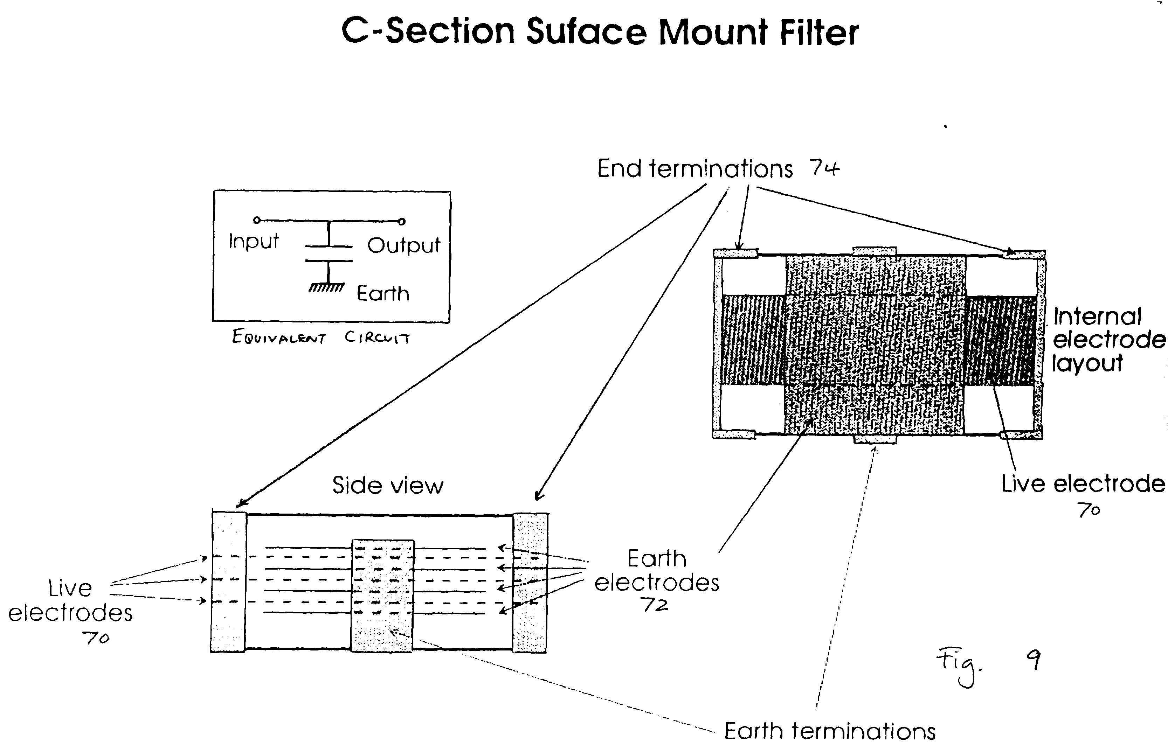

The filter 30 comprises two discoidal multi-component, multi-layer capacitors 34a, 34b. The capacitors 34a, 34b are fashioned from the same block of ceramic. The internal, external and hole electrodes are arranged such that the two end terminations 12b, 12b' are linked by the inductance of a conducting double spiral 36 on the upper surface of the component. The capacitor 34b is connected between an earth terminal 12a and end termination 12b, and the capacitor 34a is connected between the earth teminal 12a and the end termination 12b'. An equivalent circuit is illustrated in Fig. 14.

The surface 39 is preferably provided with a high magnetic permeability layer 40, such as a ferrite. In the drawings, the ferrite layer 40 is shown as being underneath the conducting spiral 36. However, in other embodiments it may be above the spiral 36 or, most preferably, the conducting spiral is disposed within a thicker layer of ferrite.

Fig. 3 illustrates a second embodiment of electronic device, in the form of a high density planar capacitance array 40. Figs. 3b to 3d illustrate schematically alternate electrode layers in the planar array 40 of Fig. 3. Fig. 3b illustrates the earth layers of internal electrode patterns, Fig. 3c illustrates the signal layers of the internal electrode patterns, and Fig. 3d illustrates the pattern of the dopant print on the top and the bottom of the signal layers.

The planar capacitance array 40 comprises a plurality of discoidal multi-layer, multi-component capacitors 44a, 44b, 44c ... 44n fashioned from a single block of ceramic and used to act as a radio frequency interference suppression filter (RFI) on an array of interconnections, such as a multi-way connector.

Before construction of the ceramic block, alternate individual layers of the ceramic block are printed with a dopant species, in the space not occupied by the electrodes, before co-firing. This dopant species diffuses during firing into the selected regions of the ceramic to accomplish a reduction in permittivity.

In a third embodiment a multi-layer, multi-composition capacitor is employed in a pressure sensor. The shape/geometry of the ceramic block is fashioned to a shape suitable for the type of pressure sensor required. For example, a simple chip capacitor may be configured as a uniaxial or shear mode sensor, whilst a discoidal arrangement might be deployed as a radial or isostatic pressure sensor.

An example of a pressure sensor incorporating such a multi-layer, multi-composition capacitor is shown in Figure 8.

The device of Fig. 8 comprises a discoidal multicomposition multilayer ceramic capacitor 50, housed inside a cylindrical body 52 which is generally electrically conducting but with one face 54 electrical insulating. One end of the body consists of a pressure plate 56 which is bonded to one 58 of the flat faces of the capacitor (it is shown slightly separated from this flat face of the capacitor in Fig. 13 for ease of illustration). The other face 60 of the capacitor is in physical contact with the other insulating face 54 of the body. A "sliding" or flexible joint 62 between the pressure plate 56 and the body 52 ensures that any pressure applied to the pressure plate 56 is transferred to the capacitor 50. The elastic compliance of the ceramic capacitor 50 is such that the required movement of the flexible contact 62 is vanishingly small. The internal termination 66 of the capacitor is in electrical contact with a pin 64 which passes through the insulating portion 54 of the body, whilst part of the external termination 68 of the capacitor is in contact with the conducting regions of the body 52. However, the majority of the external curved surface of the capacitor is not bonded to the capacitor body so as to allow for compression under pressure on the pressure plate 56.

On pressure being applied to the pressure plate 56, the pressure is transmitted to the capacitor 50. The capacitance measured between the pin 64 and the conducting portion 52 of the body is dependent upon the applied pressure and so can be used as an electrical measurement of the applied pressure. A high pressure sensitivity of capacitance is achieved through the use of the multilayer capacitor employing relaxor dielectrics. Temperature stability of the sensitivity is achieved as in other embodiments, through the use of several different relaxor compositions within the multilayer so that compensation of their temperature dependences is achieved.

The principle of using a multicomponent multi-layer capacitor, employing relaxor dielectrics, can be applied to a wide range of pressure sensing devices, all of which use a combination of relaxors to obtain improved performance in terms of a high pressure sensitivity of capacitance combined with a low temperature dependence of that sensitivity.

The device described above and illustrated in Fig. 8 is only one example of how that principle may be applied.

Fig. 9 illustrates the application of the MCMLS concept to a C-section, surface mount filter. This device comprises two interleaved electrode stacks 70,72 connected to two separate pairs of terminations 74 on the adjacent sides of the device as shown in this figure. The advantages of the MCMLS concept for this device is the high capacitance per unit volume which can be achieved in a high rated voltage component.

## Claims

1. An electronic component comprising a discoidal, multi-layer, multi-composition capacitor, which capacitor is fabricated by stacking and co-firing a plurality of differing ceramic composition layers between a plurality of metallic electrodes to form a ceramic block, the ceramic composition layers having been selected so that the compositions are compatible for co-firing and also so that each layer of a different composition exhibits a respective peak in its permittivity at a different temperature, from that of the other compositions, within a selected temperature range, wherein the number of layers and thickness of layers for each composition is selected such that the total capacitance becomes substantially equal across the complete selected temperature range when the layers are connected in parallel within the ceramic block, and wherein the disc shape of the capacitor is formed from the ceramic block before it is incorporated in the electronic component.

2. An electronic component as claimed in claim 1, in the form of a radio frequency interference suppression filter comprising two discoidal, multi-layer, multi-composition capacitors fashioned from the same block of ceramic.

3. An electronic component as claimed in claim 2, wherein an end termination of one capacitor is connected to an end termination of the other capacitor.

4. An electronic component as claimed in claim 3, wherein the connection between said end terminations is an inductance link provided by a conducting double spiral at a surface of the block.

5. An electronic component as claimed in claim 4, in which each capacitor is connected between a respective end termination and a central earth terminal.

6. An electronic component as claimed in claim 1, comprising an array of discoidal, multi-layer, multi-component capacitors fashioned from a single block of ceramic.

7. An electronic component as claimed in any of claims 1 to 6, wherein areas of said layers are selectively printed with dopant before firing the ceramic block.

8. An electronic component as claimed in claim 7, wherein the dopant is printed on alternate layers in the spaces not occupied by the electrodes.

9. An electronic component as claimed in claim 1, wherein the ceramic block is constructed from six different compositions as follows:

   I $Pb(Mg_{1/3}Nb_{2/3})O_3$

II 0.94 Pb(Mg$_{1/3}$Nb$_{2/3}$)O$_3$ - 0.06 PbTiO$_3$
III 0.9 Pb(Mg$_{1/3}$Nb$_{2/3}$)O$_3$ - 0.1 PbTiO$_3$
IV 0.85 Pb(Mg$_{1/3}$Nb$_{2/3}$)O$_3$ - 0.15 PbTiO$_3$
V 0.77 Pb(Mg$_{1/3}$Nb$_{2/3}$)O$_3$ - 0.23 PbTiO$_3$
VI Pb$_{0.985}$La$_{0.01}$(Mg$_{1/3}$Nb$_{2/3}$)O$_3$

10. An electronic component as claimed in claim 9, wherein the block is constructed from one layer of composition I, zero to three layers of composition II, one to three layers of composition III, zero to three layers of composition IV, zero to three layers of composition V, and three to six layers of composition VI.

11. An electronic component as claimed in claim 9, wherein the block is constructed from one to four layers of composition II, one layer of composition IV, zero to three layers of composition V, and three to six layers of composition VI.

12. An electronic component as claimed in claim 1, which is in the form of a temperature stable pressure sensor.

13. A temperature stable pressure sensor comprising a multi-layer, multi-composition capacitor, which capacitor is fabricated by stacking and co-firing a plurality of differing ceramic composition layers between metallic electrodes to form a ceramic block, the ceramic composition layers having been selected so that the compositions are compatible for co-firing and also so that each layer of a different composition exhibits a respective peak in its permittivity at a different temperature, from that of the other compositions, within a selected temperature range, wherein the number of layers and thickness of layers for each composition is selected such that the total capacitance becomes substantially equal across the complete selected temperature range when the layers are connected in parallel within the ceramic block.

14. A temperature stable pressure sensor as claimed in claim 13, comprising a discoidal multi-layer multicomposition capacitor housed inside a body of the sensor, one face of the capacitor being coupled to a pressure plate and the other end being fixed relative to the sensor body, such that pressure applied in use to the pressure plate causes elastic compression of the capacitor, resulting in a measurable variation of the capacitance of the capacitor related to the applied pressure.

15. An electronic component as claimed in claim 4, wherein a high magnetic permeability layer, such as a ferrite, is provided on the surface of the block over or around said inductive link.

Fig. 1
Fig. 2
Fig. 10
Fig. 11
Section X-X
Fig. 12
Section Y-Y
Fig. 13
Section Z-Z
Fig. 14

11

Section X-X

Fig. 4

Fig. 3a

Earth layers

Fig. 3b

Signal layers

Fig. 3c

Fig. 3d

| Composition I |
| Composition II |
| Composition III |
| Composition IV |
| Composition V |
| |
| |
| Composition n |

10

12a

12b

Figure 5

Fig. 6

Capacitance

A

B C

y

Temperature

Fig. 6a

Fig. 7

Fig. 8

EP 0 841 671 A2

C-Section Suface Mount Filter

Fig. 9